# EUROPEAN PATENT APPLICATION

(11) **EP 1 995 016 A1**
(43) Date of publication of application: **26.11.2008**
(21) Application number: 07707344.3
(22) Date of filing: 24.01.2007
(51) Int. Cl.: B23K 35/363, H05K 3/34

(54) **WATER-DISPERSED FLUX COMPOSITION, ELECTRONIC CIRCUIT BOARD WITH ELECTRONIC COMPONENT, AND THEIR PRODUCTION METHODS**

(30) Priority: 26.01.2006 JP 2006017350
(71) Applicant: Toeikasei Co., Ltd., Tokyo 103-0023 (JP); Asahi Chemical Research Laboratory Co., Ltd., Hachioji-shi, Tokyo 193-0812 (JP)
(72) Inventor: SHIMIZU, Hitoshi, Tsuchiura-shi Ibaraki 300-4102 (JP); OKITA, Kiyoshi, Tsuchiura-shi Ibaraki 300-4102 (JP); SUGAMA, Naoki, Tsuchiura-shi Ibaraki 300-4102 (JP); HAMASHIMA, Koji, Tsuchiura-shi Ibaraki 300-4102 (JP); MOROZUMI, Yukihiko, Tsuchiura-shi Ibaraki 300-4102 (JP); OHINATA, Takahiro, Tsuchiura-shi Ibaraki 300-4102 (JP); IWASA, Yamahiro, Hachioji-shi Tokyo 193-0812 (JP); OBA, Yoichi, Higashiyamato-shi Tokyo 207-0021 (JP)
(74) Representative: HOFFMANN EITLE
(86) International application number: PCT/JP2007/051097
(87) International publication number: WO 2007/086433

(57) **Abstract**

A water-dispersed flux composition comprises solid fine particles containing a carboxy group-containing resin, an activator, a dispersing agent, and water, in which all of the solid fine particles have a particle diameter in the range of 0.03 to 20 µm, and the ratio of solid fme particles having a particle diameter of 0.03 to 10 µm is not less than 90% by mass based on the total of solid fine particles (100% by mass).

## Description

### TECHNICAL FIELD

The present invention relates to a water-dispersed flux composition employed when soldering electronic components and the like to an electronic circuit board, to a production method therefore, to an electronic circuit board with electronic components having a flux film consisting of the water-dispersed flux composition, and to a production method for the electronic circuit board with electronic components that employs the water-dispersed flux composition.
Priority is claimed on Japanese Patent Application No. 2006-017350, filed January 26, 2006, the content of which is incorporated herein by reference.

### BACKGROUND ART

When electronic components and the like are soldered to an electronic circuit board such as a printed circuit board, a flux is used in order to carry out the soldering reliably. Fluxes also function to remove oxides from the metal surface and to prevent re-oxidation of the metal surface when soldering is carried out.
The following may be cited as examples of soldering methods:
• Flux is coated onto an electronic circuit board mounted with electronic components by foaming or spraying. After the flux is dried, solder is brought into contact with parts to be soldered, and the electronic components are soldered to the electronic circuit board.
• Flux is coated to parts to be soldered using a brush or dispenser, wire solder or a solder preform is brought into contact with the parts to be soldered, and electronic components are soldered to an electronic circuit board using a soldering iron or laser.

The fluxes employed in the soldering methods described above must possess a number of properties, including the following:
- Absence of such soldering defects as poor wetting (incomplete soldering), and formation of icicles, bridges, solder balls, etc.
- Amount of flux remaining after soldering is minimal, and what does remain is not sticky
- High electrical insulating properties after soldering, and absence of migration, etc., even if a voltage is applied in the wet state

Conventional liquid fluxes are composed from a base resin, an activator, and an organic solvent in which the base resin and activator can be uniformly dissolved. Alcohol based organic solvents including isopropyl alcohol (IPA) as the primary component are used as typical organic solvents. The ratio of the organic solvent included in the flux is typically in the range of 65 to 98% by mass. In conventional liquid fluxes, a volatile organic compound (VOC) comprises 2/3 or more of the total mass.
In recent years, however, there has been a growing desire to reduce VOCs from the perspective of protecting the environment, and this requirement has extended to the area of fluxes as well. Moreover, IPA can cause irritation and anesthesia of the skin and mucous membranes, and is classified as a dangerous substance (an inflammable substance) in attached Table 1 of the Enforcement Order of the Industrial Safety and Health Act in Japan, and is an inflammable liquid corresponding to class 4-III alcohols in the Fire Service Law in Japan. Accordingly, IPA is subject to a variety of regulations with respect to handling and storage.

In order to resolve the above problems, water-based fluxes with a decreased VOC content have been developed in recent years. For example, the following fluxes have been disclosed as water-based fluxes.
(1) A water-based soldering flux in which an ammonia or amine is added to a modified rosin or a rosin having an acid number, to form a water soluble rosin ammonium salt or amine salt, which is then dissolved in water (Patent Document 1)
(2) A flux in which a rosin modified resin having a high acid number is dissolved in water containing a volatile basic agent such as ammonia (Patent Document 2)
(3) A flux in which a covalently bonded organic halogen compound and a fluorinated surfactant are added to a water-based soldering flux that includes a rosin, an amine that saponifies the rosin, an activator, water and a trace amount of organic solvent (Patent Document 3)
(4) A water-dispersed flux in which a rosin is suspended or emulsified in water, and an activator is added to the suspended or emulsified rosin, or a water-dispersed flux in which a compatible mixture obtained by adding an activator to a rosin is suspended or emulsified in water (Patent Document 4)
(5) A flux in which at least one latex resin selected from the group consisting of rosin resins, rubber resins, and acrylic resins is dispersed in water or a mixture of water and a hydrophilic solvent (Patent Document 5)

The fluxes of (1) through (3) must contain a large amount of volatile basic compounds such as ammonia and amine in order to completely dissolve the rosin or modified rosin in water. For this reason, even if the amount of organic solvents such as IPA is reduced, it is not possible to avoid the volatilization of the volatile basic compound when coating the flux and soldering, so that the ammonia or amine odor becomes heavy and the environmental quality of the workplace is degraded. Furthermore, the basic compound which remains on the electronic circuit board after soldering may give rise to insulating defects or migration.

In contrast, the fluxes of (4) and (5) do not contain volatile basic compounds. However, in the flux of (4), there is no control over the particle diameter in the suspended rosin, and the properties as a dispersing agent or stabilizing agent are insufficient. As a result, aggregation, separation, precipitation and the like of the rosin in the flux occur within a short time (i.e., liquid stability is poor), which is greatly problematic. Likewise, the flux of (5) is similarly problematic in that the latex resin undergoes aggregation, separation, precipitation and the like in the flux within a short time (i.e., liquid stability is poor).
[Patent Document 1] Japanese Unexamined Patent Application, First Publication No. 8-132282
[Patent Document 2] Japanese Unexamined Patent Application, First Publication No. 2001-300766
[Patent Document 3] Japanese Unexamined Patent Application, First Publication No. 2002-120089
[Patent Document 4] Japanese Unexamined Patent Application, First Publication No. 49-51143
[Patent Document 5] Japanese Unexamined Patent Application, First Publication No. 7-299587

### DISCLOSURE OF THE INVENTION

### Problems to be Solved by the Invention

Accordingly, it is the purpose of the present invention to provide a water-dispersed flux composition that has superior liquid stability over a long period of time without essentially including volatile organic solvents and basic compounds, which does not readily lead to soldering defects, and for which insulating defects and migration after soldering do not readily occur; a production method of easily producing the aforementioned water-dispersed flux composition; an electronic circuit board with electronic components in which insulating defects and the occurrence of migration can be controlled, soldering defects are markedly rare, and there is almost no stickiness from any remaining flux; a production method for an electronic circuit board with electronic components in which it is possible to obtain an electronic circuit board with electronic components, and there is almost no volatilization of organic solvents and basic compounds during production; and a method for soldering in which there is almost no volatilization of organic solvents and basic compounds during soldering.

### Means for Solving the Problems

A water-dispersed flux composition according to the present invention is characterized by containing solid fine particles containing a carboxy group-containing resin, an activator, a dispersing agent and water, in which all of the solid fine particles have a particle diameter in the range of 0.03 to 20 µm, and the ratio of solid fine particles having a particle diameter of 0.03 to 10 µm is not less than 90% by mass based on the total of solid fine particles (100% by mass).

A dispersing agent is preferably at least one type from among the compounds cited in the following (a) to (f).
(a) Nonionic surfactants such as polyoxyalkylene polycyclic aryl ether expressed by chemical formula (1) below, fatty acid alkanol amide, polyoxyalkylene sorbitan alkylate, and polyalkylene glycol fatty acid ester

   R¹-O-(R²O)ₙ-H (1)

   where R¹ is a polycyclic aromatic group having an alkylaryl group or an alkyl group with two or more benzene rings, R² is an alkylene group having 2 to 3 carbons, and n is an integer in the range of 2 to 40
(b) Anionic surfactants such as phosphates and sulfates
(c) Cationic surfactants such as quaternary ammoniums
(d) High molecular compounds such as polyacrylate, polyvinyl pyrrolidone, polyacrylamide
(e) Layered clay minerals such as kaolinite, halloysite, montmorillonite, illite, and vermiculite
(f) Silica compounds such as colloidal silica

A method of producing a water-dispersed flux composition according to the present invention is characterized by adding a carboxy group-containing resin being the solid state and an activator to a medium consisting of water and a dispersing agent, processing the carboxy group-containing resin in the solid state into fine particles, and dispersing the fine particles in the medium.
An electronic circuit board with electronic components according to the present invention is characterized by having soldered electronic components and a flux film consisting of the water-dispersed flux composition of the present invention on an electronic circuit board.
A method of producing an electronic circuit board with electronic components according to the present invention is characterized by applying the water-dispersed flux composition of the present invention to the electronic circuit board and then soldering the electronic components to the electronic circuit board.
A soldering method according to the present invention is characterized by employing the water-dispersed flux composition of the present invention.

### Effect of the Invention

The water-dispersed flux composition according to the present invention has superior liquid stability over a long period of time without essentially including volatile organic solvents or basic compounds, in which soldering defects, and insulating defects and migration after soldering are not prone to occur.
The method of producing the water-dispersed flux composition according to the present invention enables to easily produce a water-dispersed flux composition that has superior liquid stability over a long period of time without essentially including volatile organic solvents or basic compounds, in which soldering defects are not prone to occur, and for which insulating defects and migration after soldering can be controlled.

In the electronic circuit board with electronic components according to the present invention, insulating defects and the occurrence of migration are controlled, soldering defects are markedly reduced, and there is almost no stickiness from the flux film that remains.
In the method for producing the electronic circuit board with electronic components according to the present invention, it is possible to provide an electronic circuit board with electronic components in which the insulating defects and the occurrence of migration are controlled, soldering defects are markedly reduced, and there is almost no stickiness from any remaining flux film. Further, volatilization of organic solvent and basic compounds during production is almost entirely absent.
In the soldering method according to the present invention, there is almost no volatilization of organic solvent and basic compounds during soldering.

### Best Mode for Carrying Out the Invention

### Water-dispersed flux composition

The water-dispersed flux composition according to the present invention contains solid fine particles, an activator, a dispersing agent, and water.

### Solid fine particles

The solid fine particles have a carboxy group-containing resin as the main component. Other resins and various additives may be included within limits that do not impair the effects of the present invention.
Any resin containing a carboxy group is acceptable for the carboxy group-containing resin, examples thereof include rosins such as gum rosin, wood rosin, tall rosin, refined rosin, and the like; rosin modified derivatives such as polymer rosin, disproportioned rosin, hydrogenated rosin, phenol modified rosin, acrylic acid modified rosin, fumaric acid modified rosin, maleic acid modified rosin, and the like; and synthetic resins such as styrene-maleic acid resin, acrylic resin, and the like. Rosins and rosin modified derivatives are particularly preferred.

The acid number of the carboxy group-containing resin is preferably in the range of 50 to 300 mg KOH/g, more preferably in the range of 70 to 280 mg KOH/g, and particularly preferably in the range of 100 to 250 mg KOH/g.
The softening point of the carboxy group-containing resin is preferably in the range of 50 to 200°C, more preferably in the range of 60 to 180°C, and particularly preferably in the range of 70 to 150°C.
The carboxy group-containing resin may be used alone or as a mixture of two or more kinds.
The amount of carboxy group-containing resin is preferably in the range of 0.5 to 50% by mass, more preferably in the range of 1 to 40% by mass, and particularly preferably in the range of 2 to 30% by mass based on the water-dispersed flux composition (100% by mass).

It is a major characteristic of the present invention that the carboxy group-containing resin is processed from the solid state to fine particles, and then uniformly dispersed into a medium (dispersion medium) consisting of water and a dispersing agent. Namely, the fine particles are solid and the medium is liquid, i.e., a so-called "suspension" state is an essential aspect of the present invention, and is different from a so-called "emulsion", in which both the fine particles and the medium are liquids. In the emulsion state, the various properties (electrical properties, soldering ability, liquid stability, etc.) required of a flux cannot be satisfied.

In order to obtain a water-dispersed flux composition that satisfies the various properties required of a flux, it is extremely important to control the particle diameter of the solid fine particles. Namely, these various properties can be satisfied by a water-dispersed flux composition in which all of the solid fine particles have a particle diameter in the range of 0.03 to 20 µm, and the ratio of solid fine particles having a particle diameter in the range of 0.03 to 10 µm is not less than 90% by mass based on the total solid fine particles (100% by mass). When solid fine particles having a particle diameter of less than 0.03 µm are included, reaggregate of the solid fine particles occurs frequently, undesirable precipitation, separation, etc. occur. Therefore, it is not possible to satisfy the various properties required of a flux. Conversely, when the solid fine particles having a particle diameter that exceeds 20 µm are included, the liquid stability greatly decreases, non-uniform coating, thick coating, etc. may occur when coating the water-dispersed flux composition to the electronic circuit board, and also stickiness and a deterioration of electrical properties, etc. may occur.

In the present invention, it is preferable that all of the solid fine particles have a particle diameter in the range of 0.03 to 10 µm, with a particle diameter in the range of 0.03 to 5 µm being particularly preferred.
The particle diameter of the solid fine particles is measured under the following conditions using a laser diffraction/dispersing type particle distribution measuring device (MT-3300 EXII, manufactured by Nikkiso Co., Ltd.).
- Measuring conditions:: Refractive index of water = 1.333
Refractive index of solid fine particles =1.55
Measurement temperature = room temperature

### Dispersing agent

The dispersing agent is a component for improving the properties required of the flux by enabling stable dispersion of the solid fine particles over a long period of time.
Examples of the dispersing agent include nonionic surfactants, anionic surfactants, cationic surfactants, high molecular compounds, layered clay minerals, and silica compounds.

The dispersing agent is preferably at least one type from among the compounds cited in the following (a)~(f).
(a) Nonionic surfactants such as polyoxyalkylene polycyclic aryl ether expressed by chemical formula (1) below, fatty acid alkanol amide, polyoxyalkylene sorbitan alkylate, and polyalkylene glycol fatty acid ester

   R¹-O-(R²O)ₙ-H (1)

   Where R¹ is a polycyclic aromatic group having an alkylaryl group or an alkyl group with two or more benzene rings, R² is an alkylene group having 2~3 carbons, and n is an integer in the range of 2 to 40.
(b) Anionic surfactants such as phosphates and sulfate
(c) Cationic surfactants such as quaternary ammoniums
(d) High molecular compounds such as polyacrylate, polyvinyl pyrrolidone, and polyacrylamide
(e) Layered clay minerals such as kaolinite, halloysite, montmorillonite, illite, and vermiculite
(f) Silica compounds such as colloidal silica

The nonionic surfactants cited in (a) are preferably used as the dispersing agent. Among them, polyoxyalkylene polycyclic aryl ether expressed by chemical formula (1), fatty acid alkanol amide, polyoxyalkylene sorbitan alkylate, and polyalkylene glycol fatty acid ester are more preferred, and the polyoxyalkylene polycyclic aryl ether expressed by chemical formula (1) are particularly preferred.

Examples of the polyoxyalkylene polycyclic aryl ether expressed by chemical formula (1) include polyoxyalkylene mono (or di- or tri-) tolyl phenylether, polyoxyalkylene mono (or di- or tri-) xylyl phenylether, polyoxyalkylene mono (or di- or tri-) styryl phenylether, polyoxyalkylene mono (or di- or tri-) tolyl alkyl phenylether, polyoxyalkylene mono (or di- or tri-) xylyl alkyl phenylether, polyoxyalkylene mono (or di- or tri-) styryl alkyl phenylether, polyoxyalkylene mono (or di- or tri-) naphthyl phenylether, polyoxyalkylene mono (or di- or tri-) naphthyl alkyl phenylether, polyoxyalkylene mono (or di- or tri-) (phenylalkyl) substituted phenylether, polyoxyalkylene mono (or di- or tri-) (phenylalkyl) substituted tolyl ether, polyoxyalkylene mono (or di- or tri-) (phenylalkyl) substituted xylyl ether, and the like.
From among the polyoxyalkylene polycyclic aryl ethers expressed by chemical formula (1), one having a HLB (hydrophilic-lipophilic balance) equal to 14 to 18 is particularly preferred.

Examples of the fatty acid alkanol amides include lauric acid mono (or di-) ethanol amide, oleic acid mono (or di-) ethanol amide, coconut oil fatty acid mono (or di-) ethanol amide, myristic acid mono (or di-) ethanol amide, stearic acid mono (or di-) ethanol amide, or the like.
Examples of the polyoxyalkylene sorbitan alkylate include polyoxyethylene sorbitan mono (or di- or tri-) laurate, polyoxyethylene sorbitan mono (or di- or tri-) stearate, polyoxyethylene sorbitan mono (or di- or tri-) oleate, and the like.
Examples of the polyalkylene glycol fatty acid ester include polyoxyethylene mono laurate, polyoxyethylene mono stearate, polyoxyethylene mono oleate, and the like.

Examples of phosphate salts include alkyl phenol ether phosphate salt, alkyl ether phosphate salt, and the like.
Examples of sulfate salts include polyoxyethylene alkyl ether sulfate salt, polyoxyethylene polycyclic phenyl ether sulfate salt, polyoxyethylene alkyl ether sulfate salt, and the like.
Examples of quaternary ammonium salt include alkyl benzyl ammonium chloride salt, stearyl trimethyl ammonium chloride, alkyl ammonium hydroxide, and the like.

The dispersing agent may be employed alone or in combination of two or more kinds.
The amount of dispersing agent added is preferably in the range of 1 to 40 parts by mass, more preferably in the range of 3 to 35 parts by mass, and particularly preferably in the range of 5 to 30 parts by mass based on 100 parts by mass of the solid fine particles.

### Activator

Conventionally known activators for fluxes can be used, examples of activators include organic acids, hydrohalide of amine, double salts of an organic acid and an amine, an organic halogenated compound, alkyl ester phosphates, and the like. Organic acids and hydrohalide of amine are preferred for activators.
Examples of organic acids include formic acid, acetic acid, propionic acid, tartaric acid, citric acid, malic acid, glycolic acid, gluconic acid, malonic acid, succinic acid, glutaric acid, adipic acid, pimelic acid, suberic acid, azelaic acid, sebacic acid, picolinic acid, and the like.

Examples of the hydrohalide of amine include amine hydrochloride, amine hydrobromide, amine hydrofluoride, and the like. Examples of the aforementioned amines include monomethyl amine, dimethyl amine, trimethyl amine, monoethyl amine, diethyl amine, triethyl amine, n-propyl amine, isopropyl amine, n-butyl amine, sec-butyl amine, tert-butyl amine, di-isobutyl amine, n-octyl amine, cyclohexyl amine, pyridine, and the like.

Double salts of the aforementioned organic acids and amines may be cited as examples of a double salt of an organic acid and an amine.
Examples of the organic halogenated compound include monochloroacetate, dichloroacetate, bromoethanol, bromopropanol, bromobutanol, bromopropane diol, dibromoethanol, dibromopropanol, dibromobutanol, dibromopropane diol, dibromobutene diol, bromoethylacetate, bromosuccinate, dibromosuccinate, and the like
Examples of the alkyl ester phosphates include diisodecylphosphate, 2-ethyl hexyl-2-ethyl hexyl phosphonate, 2-ethylhexyl acid phosphate, isodecyl phophate, lauryl phosphate, tridecyl phophate, stearyl phosphate, oleyl acid phosphate, bis(2-ethylhexyl)phosphate, and the like.
The amount of activator included is preferably in the range of 0.05 to 10% by mass, more preferably 0.1 to 5% by mass, and particularly preferably 0.2 to 3% by mass based on the water-dispersed flux composition (100% by mass).

### Water

Water is not particularly restricted as long as it is one that does not have any effects on the various properties required of the flux (i.e., electrical properties, soldering properties, liquid stability, etc.), suitable examples thereof including ion-exchanged water, distilled water, ultrapure water, RO water, tap water, and the like.
The amount of water included is the remainder excluding the solid fine particles, dispersing agent, activator, and other components which will be described below.

### Other components

Other additives that are employed in conventional fluxes may be added to the water-dispersed flux composition according to the present invention, such as activators, icicle preventing agents, delustering agents, flame retarding agents, antioxidizers, defoaming agents, anti-mold agents (fungicides), thixotropic agents, evaporation rate controlling agents, and the like.
Organic solvents may be suitably added to the water-dispersed flux composition according to the present invention within a range which does not deviate from the essence of the invention. Suitable examples thereof which may be cited include alcohols, glycols, glycol ethers, esters, amides, ketones, ethers, hydrocarbons, and the like.

In the above-described water-dispersed flux composition according to the present invention, all of the solid fine particles have a particle diameter in the range of 0.03 to 20 µm, and the ratio of solid fine particles having a particle diameter of 0.03 to 10 µm is not less than 90% by mass based on the total of solid fine particles (100% by mass). As a result, the water-dispersed flux composition according to the present invention has superior liquid stability over a long period of time, soldering defects do not readily occur, insulating defects and the occurrence of migration after soldering does not readily occur. Furthermore, the carboxy group-containing resin is processed from the solid state to fine particles, and the fine particles are uniformly distributed in a medium consisting of water and a dispersing agent.
As a result, it is not necessary to add a volatile organic agent and a basic compound.

Because a volatile organic solvent and a basic compound are not essentially included, the following benefits are present.
- Adverse effects on the environment and the human body are markedly little, and the danger of flammability is absent. As a result, imparting the explosion-proof property to the flux coating device and the soldering device becomes unnecessary. Transport and storage are also facilitated. In addition, changes in the flux composition due to volatility of the organic solvent are almost non-existent, so that the composition has excellent stability.
- Unpleasant odors arising from basic compounds such as ammonia, amine, etc. during soldering are absent, so that there is little impact on personnel.
- Insulating defects and the occurrence of migration following soldering which arise from the basic compounds is controlled.

### Method of producing water-dispersed flux composition

In the method of producing the water-dispersed flux composition according to the present invention, the carboxy group-included resin in a solid state, which is not a melted or solution state, and an activator are added to a medium consisting of water and a dispersing agent, and the carboxy group-containing resin is processed from the solid state to fine particles to disperse the fine particles in the medium.

The following methods may be cited as methods of producing the specific water-dispersed flux composition.
(i) The carboxy group-containing resin in solid form is added to a medium consisting of water and a dispersing agent, and then processed from the solid state to fine particles using a mill, nanomizer, high speed mixer, homogenizer, ultrasonic device, or other means, to be dispersed uniformly in the medium.
(ii) The carboxy group-containing resin in the solid state is first processed to fine particles using a mill or the like, and the solid fine particles then dispersed in the medium.
   Method (i) above is preferable from the perspective of the stability of the solid particles and the various characteristics required of the flux.

The following methods may be cited as methods for adding the activator.
(iii) The carboxy group-containing resin and activator are kneaded first, prior to dispersion in the medium.
(iv) The carboxy group-containing resin is processed to fine particles to be uniformly dispersed in the medium, and then added to the dispersing liquid.
   Method (iii) above is preferable from the perspective of the mixing state of the carboxy group-containing resin and the activator.

The following methods may be cited as methods for mixing the carboxy group-containing resin and the activator in advance.
(v) The carboxy group-containing resin and activator are heated to a temperature above the melting point, and then melt-kneaded.
(vi) The carboxy group-containing resin and activator are first dissolved in a solvent, and then the solvent is subjected to vacuum distillation or is removed using a spray drier.
(vii) The carboxy group-containing resin and activator are mechanically kneaded using a mill, pressurized extruder, biaxial kneader, etc.
   Method (v) above is preferable from the perspective of the mixing state of the carboxy group-containing resin and the activator.

In the above-described method for producing the water-dispersed flux composition according to the present invention, the carboxy group-included resin in a solid state and the activator are added to a medium consisting of water and a dispersing agent, the carboxy group-containing resin in the solid state is processed to fine particles, and then dispersed in the medium. As a result, it is possible to produce the composition using a relatively simple device without requiring high temperatures and pressures. Accordingly, the water-dispersed flux composition of the present invention can be easily produced.

### Electronic circuit board with electronic components

The electronic circuit board with electronic components according to the present invention has a flux film consisting of the water-dispersed flux composition and soldered electronic components.
The electronic circuit board with electronic components is produced by coating the water-dispersed flux composition onto an electronic circuit board, and then soldering the electronic components to the electronic circuit board.

The following methods may be cited as soldering methods.
- The electronic circuit board on which electronic components are mounted is coated with the water-dispersed flux composition and the coated board is dried, after which the solder is brought into contact with the parts to be soldered.
- The water-dispersed flux composition is applied to the components to be soldered using a brush or dispenser, after which wire solder or a solder preform is brought into contact with the parts to be soldered.

Methods such as a foaming method, spraying method, brush coating method, roller coating method, and the like may be cited as methods for coating the electronic circuit board with the water-dispersed flux composition.
Various methods such as a room temperature drying method or a heating and drying method may be cited as methods for drying the water-dispersed flux composition, as long as these methods enable the flux film to be formed onto the electronic circuit board.
Various methods may be cited for bringing the solder into contact, jet soldering; reflow soldering; and a method in which wire soldering or a soldering perform is brought into contact with the soldered part, and soldering is performed using a soldering iron or laser are exemplified.

While the flux film remains on the electronic circuit board, it does not have any impact on the insulating properties and therefore need not be removed by washing. Moreover, when a circuit wire pattern is formed from a copper clad laminate by etching, followed by coating the circuit wire pattern with the water-dispersed flux composition of the present invention to form, then the flux film formed in this way serves as a protective film for controlling oxidation of the copper circuit wiring until the soldering operation.

In the electronic circuit board with electronic components according to the present invention as described above, a flux film consisting of the water-dispersed flux composition and soldered electronic components are present on the electronic circuit board. As a result, it is possible to control insulating defects and the occurrence of migration, soldering defects are markedly reduced, and there is very little stickiness from the flux film that remains.

In the method of producing an electronic circuit board with electronic components according to the present invention as described above, since the water-dispersed flux composition according to the present invention is employed, it is possible to obtain an electronic circuit board with electronic components in which the insulating defects and the occurrence of migration can be controlled, poor soldering is limited, and there is very little stickiness from the flux film that remains. In addition, there is almost no volatilization of organic solvent and basic compound during production.

By employing a water-dispersed flux composition in which a volatile organic solvent and a basic compound are essentially not included, the following benefits are present.
- The danger of flammability is absent. As a result, imparting the explosion-proof property to the flux coating device and the soldering device becomes unnecessary.
- Unpleasant odors arising from basic compounds such as ammonia, amine, etc. during soldering are absent, so that there is little impact on the human body.
- Insulating defects and the occurrence of migration following soldering which arise from basic compounds is controlled.

Note that the water-dispersed flux composition according to the present invention is not limited to soldering of electronic circuit boards and electronic components. Rather, the water-dispersed flux composition may also be employed in a various types of soldering, including soldering of electronic circuit boards and conductive wiring, soldering of connectors and conductive wiring, soldering between conductive wiring, and soldering of various types of metallic components.

### Examples

The present invention will now be explained more concretely by citing various examples thereof. Note, however, that the present invention is not limited thereto.
A variety of measurements and evaluations were carried out as follows.

### Particle diameter of solid fine particles

The particle diameter of solid fine particles in flux was measured under the following conditions using a laser diffraction/dispersing type particle distribution measuring device (MT-3300 EXII, manufactured by Nikkiso Co., Ltd.). The range of the particle diameters of all of the solid fine particles and the ratio of solid fine particles having a particle diameter in the range of 0.03 to 10 µm were determined.
- Measuring conditions:: Refractive index of water = 1.333
Refractive index of solid fine particles =1.55
Measurement temperature = room temperature

### Soldering defects and odor

The flux was coated to a mounting substrate at a proportion of 0.1 ml/16 cm² (soldering sites = 200 points), and a jet-type automatic soldering device was employed to carry out soldering under the following conditions. The number of sites where such soldering defects as incomplete soldering (poor wetting), icicles, bridges, solder balls, blow balls, etc. occurred was counted. The presence or absence of odor during soldering was also noted.
- Soldering conditions:: Conveyor speed = 0.64 m/min
Preheating temperature = 105 to 115°C
Soldering temperature = 250°C

### Insulation resistance

Testing of the insulation resistance of the flux was carried out in accordance with JIS Z3197, using type II comb-type electrodes.

### Solder spread factor

The solder spread factor of the flux was evaluated according to JIS Z3197. Specifically, 0.3 g of solder particles (Sn : 3.0Ag : 0.5Cu) was placed in the center of an acid-washed 30 mm square copper plate, and 0.05 ml of flux was dropped onto the solder particles, followed by heating to 100°C and drying for 5 minutes. The solder was melted in a solder bath set to 255°C, and left to stand for 30 seconds.

### Liquid stability

500 ml of flux was introduced into a glass container, sealed, and maintained for 90 days in a thermostatic chamber at 25°C, and the number of days until precipitation, aggregation, separation, etc., of the flux component occurred was investigated.

### Flash point

The flash point of the flux was measured using a Tag closed type measuring device and a Cleveland open type measuring device.

The various components employed in these examples are as follows below.

### Carboxy group-containing resin

Purified rosin: Shiragiku rosin manufactured by Arakawa Chemical Industries, Ltd., acid number = 200 mg KOH/g, softening point = 120°C.
Acid modified rosin: KE-604 manufactured by Arakawa Chemical Industries, Ltd., acid number = 240 mg KOH/g, softening point = 120°C.
Acrylic resin: "DIANAL" manufactured by Mitsubishi Rayon Co., Ltd.

### Dispersing agent

- Dispersing agent A:: polyoxyethylene ethylnapthyl ether, NYUCOL manufactured by Nippon Nyukazai Co., Ltd., HLB = 14.6.
- Dispersing agent B:: polyoxyethylene styrylmethylphenyl ether, NYUCOL manufactured by Nippon Nyukazai Co., Ltd., HLB = 16.6.
- Dispersing agent C:: polyoxyethylene methylbis(phenyl ethyl)phenyl ether, NYUCOL manufactured by Nippon Nyukazai Co., Ltd., HLB = 16.6.
- Dispersing agent D:: polyoxyethylene sorbitan laurate, NYUCOL manufactured by Nippon Nyukazai Co., Ltd.
- Dispersing agent E:: polyoxyethylene alkyl ether sulfate salt, NYUCOL manufactured by Nippon Nyukazai Co., Ltd.
- Dispersing agent F:: polyvinylpyrrolidone, "SOKALAN" manufactured by BASF.
- Dispersing agent G:: montmorillonite, BENGEL manufactured by HOJUN Co., Ltd.
- Dispersing agent H:: colloidal silica, "AEROSIL" manufactured by Nippon Aerosil Co., Ltd.
- Dispersing agent I:: polyoxyethylene alkylphenyl, NYUCOL manufactured by Nippon Nyukazai Co., Ltd.
- Dispersing agent J:: polyoxyethylene lauryl ether, NOIGEN manufactured by Dai-ichi Kogyo Seiyaku Co., Ltd.

### Example 1

400 g of purified rosin employed as the carboxy group-containing resin, 20 g of adipic acid and 32 g of diethylamine hydrobromide employed as activators, and 40 g of delustering agent (stearic acid) were added to an agitator made of SUS (stainless used steel), and were melt kneaded for 5 minutes at 150°C to obtain a mixture. The mixture was cooled up to a solid state, which was then coarsely ground in a grinder to provide a coarse ground substance. The coarse ground substance and 40 g of dispersing agent A were introduced into 3468 g of pure water, and dispersed in advance over 5 minutes in the agitator. Next, the mixture was treated for 2 hours in a zirconia bead mill (bead diameter = 0.3 mm) to obtain a milky white uniform water-dispersed flux composition. This water-dispersed flux composition was measured and evaluated as described above. These results are shown in Table 1.

### Examples 2 to 18

With the exception that the components and mixing ratios were changed as shown in Tables 1 and 2, a water-dispersed flux composition was obtained in the same way as in Example 1. The water-dispersed flux composition was measured and evaluated as described above. These results are shown in Tables 1 and 2.

### Comparative Example 1

While stirring 200 g of a 2% by weight polyvinyl alcohol aqueous solution heated to 95°C, 50 g of purified rosin which had been heated to 120°C and melted was added thereto. This mixture continued to be stirred, to obtain a rosin suspension. 2% by weight ammonium oxalate and 0.01% by weight of a fluorine derived surfactant (perfluoroalkyl polyoxyethylene ethanol) were added to the rosin suspension, to obtain a flux in suspension form. The flux was measured and evaluated as described above. These results are shown in Table 3.

### Comparative Examples 2 to 4

With the exception that the components and mixing ratios were changed as shown in Table 3, a flux was obtained in the same way as in Example 1. The flux was measured and evaluated as described above. These results are shown in Table 3.

### Comparative Example 5

With the exception that the components and mixing ratios were changed as shown in Table 3 and the treatment time in a zirconia bead mill was 20 minutes, a flux was obtained in the same way as in Example 1. This flux was measured and evaluated as described above. These results are shown in Table 3.

The components shown in Table 3 were stirred and mixed, to obtain a liquid flux. This flux was measured and evaluated as described above. These results are shown in Table 3.

**Table 1**

| Component(% by mass) | | | Ex. 1 | Ex.2 | Ex. 3 | Ex. 4 | Ex. 5 | Ex. 6 | Ex. 7 | Ex. 8 | Ex. 9 |
|---|---|---|---|---|---|---|---|---|---|---|---|
| Carboxy goup-containing resin | Purified rosin | | 10 | 5 | 30 | - | - | - | - | - | - |
| | Acid modified rosin | | - | - | - | 10 | 10 | 10 | 8 | 15 | 20 |
| | Acrylic resin | | - | - | - | - | - | - | - | - | - |
| Dispersing agent | Dispersing agent A | | 1 | 0.5 | - | - | - | - | - | - | - |
| | Dispersing agent B | | - | - | 3 | 0.6 | 0.6 | 0.6 | - | - | - |
| | Dispersing agent C | | - | - | - | - | - | - | 0.6 | - | - |
| | Dispersing agent D | | - | - | - | - | - | - | - | 3 | |
| | Dispersing agent E | | - | - | - | - | - | - | - | - | 2 |
| Activator | Adipic acid | | 0.5 | 0.5 | 0.5 | 0.5 | 0.5 | 0.5 | 0.4 | 0.2 | 0.5 |
| | Diethylamine hydrobromide | | 0.8 | 0.8 | 0.8 | 0.8 | 0.5 | 0.1 | 0.2 | 0.4 | 0.8 |
| Delustering agent | | | 1 | 1 | 1 | 1 | 1 | 1 | 1 | 1 | 1 |
| IPA | | | - | - | - | - | - | - | - | - | - |
| Pure water | | | 86.7 | 92.2 | 64.7 | 87.1 | 87.4 | 87.8 | 89.8 | 80.4 | 75.7 |
| Total | | | 100 | 100 | 100 | 100 | 100 | 100 | 100 | 100 | 100 |
| Range of particle diameter of all of solid fine particles [µm] | | | 0.1-2 | 0.1-2 | 0.1-1 | 0.1-1 | 0.1-1 | 0.1-1 | 0.05-1 | 0.2-6 | 0.2-8 |
| Ratio of solid fine particles having a particle diameter in the range of 0.03 to 10 µm (% by mass) | | | 100 | 100 | 100 | 100 | 100 | 100 | 100 | 100 | 100 |
| Evaluation | Number of sites of soldering defects | | 0 | 0 | 0 | 0 | 0 | 0 | 0 | 2 | 4 |
| | Insulation resistance (Ω) | Initial | 2×10¹⁰ | | | | | | | | |
| | | After 168 hours | 1×10¹⁰ | 1×10¹⁰ | 2×10¹⁰ | 3×10¹⁰ | 4×10¹⁰ | 5×10¹⁰ | 5×10¹⁰ | 5×10⁹ | 4×10⁹ |
| | Solder spread factor (%) | | 82 | 81 | 82 | 84 | 84 | 85 | 86 | 76 | 75 |
| | Liquid stability (days) | | 90 or more | 90 or more | 90 or more | 90 or more | 90 or more | 90 or more | 90 or more | 85 | 80 |
| | Odor | | None | None | None | None | None | None | None | None | None |
| | Flash point (°C) | | None | None | None | None | None | None | None | None | None |

**Table 2**

| Component(% by mass) | | | Ex. 10 | Ex. 11 | Ex. 12 | Ex. 13 | Ex. 14 | Ex. 15 | Ex. 16 | Ex. 17 | Ex. 18 |
|---|---|---|---|---|---|---|---|---|---|---|---|
| Carboy group-containing resin | Purified rosin | | - | - | - | - | 5 | - | - | 5 | |
| | Acid modified rosin | | - | 10 | - | 15 | 5 | 10 | - | - | 5 |
| | Acrylic resin | | 3 | - | 15 | - | - | - | 35 | 5 | 15 |
| Dispersing agent | Dispersing agent A | | - | - | - | 0.2 | - | - | 3 | - | - |
| | Dispersing agent B | | - | - | - | 0.3 | 0.5 | - | - | - | - |
| | Dispersing agent C | | - | - | - | - | - | 0.1 | - | - | - |
| | Dispersing agent D | | - | - | - | - | - | - | 0.5 | - | - |
| | Dispersing agent E | | - | - | - | - | - | 0.1 | - | - | 2 |
| | Dispersing agent F | | 0.3 | - | - | - | 0.1 | - | - | - | 1 |
| | Dispersing agent G | | - | 1 | - | - | - | - | - | - | - |
| | Dispersing agent H | | - | - | 1.5 | - | - | - | - | - | - |
| Activator | Adipic acid | | 0.5 | 0.5 | 0.5 | 0.5 | 0.5 | 0.5 | 0.5 | 0.5 | 0.5 |
| | Diethylamine hydrobromide | | 0.8 | 0.8 | 0.8 | 0.8 | 0.8 | 0.8 | 0.8 | 0.8 | 0.8 |
| Delustering agent | | | 1 | 1 | 1 | 1 | 1 | 1 | 1 | 1 | 1 |
| IPA | | | - | - | - | - | - | - | 10 | - | - |
| Pure water | | | 94.4 | 86.7 | 81.2 | 82.2 | 87.1 | 87.5 | 49.2 | 86.2 | 74.7 |
| Total | | | 100 | 100 | 100 | 100 | 100 | 100 | 100 | 100 | 100 |
| Range of particle diameter of all of solid fine particles [µm] | | | 0.3-8 | 1-18 | 0.5-8 | 0.1-1 | 0.1-1 | 0.07-1 | 0.1-2 | 0.1-4 | 1-8 |
| Ratio of solid fine particles having a particle diameter in the range of 0.03 to 10 µm (% by mass) | | | 100 | 90 | 100 | 100 | 100 | 100 | 100 | 100 | 100 |
| Evaluation | Number of sites of soldering defects | | 1 | 4 | 7 | 0 | 0 | 0 | 0 | 0 | 4 |
| | Insulation resistance (Ω) | After 168 hours | 4×10⁹ | 5×10⁹ | 5×10⁹ | 2×10¹⁰ | 1×10¹⁰ | 3×10¹⁰ | 2×10¹⁰ | 1×10¹⁰ | 4×10⁹ |
| | Solder spread factor (%) | | 73 | 77 | 75 | 82 | 81 | 84 | 80 | 81 | 75 |
| | Liquid stability (days) | | 80 | 75 | 80 | 90 or more | 90 or more | 90 or more | 90 or more | 90 or more | 80 |
| | Odor | | None | None | None | None | None | None | None | None | None |
| | Flash point (°C) | | None | None | None | None | None | None | None | None | None |

**Table 3**

| Component(% by mass) | | | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 |
|---|---|---|---|---|---|---|---|---|---|---|
| Rosin | Purified rosin | | - | 10 | 10 | 10 | 10 | - | - | - |
| | Acid modified rosin | | - | - | - | - | - | 10 | 20 | 15 |
| Dispersing agent A | Dispersing agent A | | - | - | - | | 1 | - | - | - |
| | Dispersing agent I | | - | 1 | - | - | - | - | - | - |
| | Dispersing agent J | | - | - | 1 | - | - | - | - | - |
| Activator | Adipic acid | | - | 0.5 | 0.5 | 0.5 | 0.5 | 0.5 | 0.5 | 0.5 |
| | Diethylamine hydrobromide | | - | 0.8 | 0.8 | 0.8 | 0.8 | 0.8 | 0.8 | 0.8 |
| Amine | Ammonia water | | - | - | - | - | - | - | 5 | - |
| | Ethyl amine | | - | - | - | - | - | - | - | 5 |
| Delustering agent | | | - | 1 | 1 | 1 | 1 | 1 | 1 | 1 |
| IPA | | | - | - | - | - | - | 87.7 | 20 | 20 |
| Pure water | | | - | 86.7 | 86.7 | 87.7 | 86.7 | - | 52.7 | 57.7 |
| Total | | | - | 100 | 100 | 100 | 100 | 100 | 100 | 100 |
| Range of particle diameter of all of solid fine particles [µm] | | | 15-25 | 20-30 | 15-20 | 50-80 | 3-15 | Completely dissolved | Completely dissolved | Completely dissolved |
| Ratio of solid fine particles having a particle diameter in the range of 0.03 to 10 µm (% by mass) | | | 0 | 0 | 0 | 0 | 80 | | | |
| Evaluation | Number of sites of soldering defects | | 25 | 32 | 45 | 120 | 15 | 13 | 19 | 22 |
| | Insulation resistance (Ω) | Initial | 3×10⁸ | | | | | | | |
| | | After 168 hours | 1×10⁸ | 5×10⁸ | 2×10⁸ | 5×10⁷ | 8×10⁸ | 1×10¹⁰ | 5×10⁸ | 8×10⁸ |
| | Solder spread factor (%) | | 68 | 68 | 65 | 51 | 70 | 74 | 72 | 73 |
| | Liquid stability (days) | | 30 | 10 | 14 | 1 | 45 | - | - | - |
| | Odor | | None | None | None | None | None | Exist | Strong | Strong |
| | Flash point (°C) | | None | None | None | None | None | 14 | None | None |

The water-dispersed flux compositions of Examples 1 to 18 did not experience aggregation, precipitation, or the like of the solid fine particles over a long period of time, and demonstrated excellent soldering and electrical properties as compared to conventional fluxes. Moreover, the flux compositions of Examples 1 to 18 did not give off an unpleasant odor, nor was a flash point observed.

In contrast, as shown by Comparative Examples 1~to 4, when the diameter of all of the solid fine particles was not in the range of 0.03 to 20 µm, then aggregation, precipitation, etc. of the solid fine particles occurred within a short period of time, and soldering and electrical properties were inferior. In addition, as shown by Comparative Example 5, when the proportion of solid fine particles having a diameter in the range of 0.03 to 10 µm was less than 90% by mass, then soldering properties, electrical properties, and liquid stability were not sufficient. Comparative Example 6 employed a conventional flux that uses IPA. In this case, there was an unpleasant odor during soldering and the flash point was low. Comparative Examples 7 and 8 employed ammonia or amine, so that a strong odor occurred during soldering, and the soldering and electrical properties were not adequate.

### INDUSTRIAL APPLICABILITY

The present invention's water-dispersed flux composition responds to the desire to reduce the use of VOCs, and does not have the problematic aspects that arise from the use of basic compounds. As a result, the water-dispersed flux composition according to the present invention is ideally employed when soldering electronic circuit boards and electronic components.

## Claims

1. A water-dispersed flux composition, comprising: solid fine particles containing a carboxy group-containing resin, an activator, a dispersing agent, and water,
wherein all of the solid fine particles have a particle diameter in the range of 0.03 to 20 µm, and the ratio of solid fine particles having a particle diameter of 0.03 to 10 µm is not less than 90% by mass based on the total of solid fine particles (100% by mass).

2. A water-dispersed flux composition according to claim 1, in which the dispersing agent is at least one type from among the compounds cited in the following (a) to (f).
(a) Nonionic surfactants such as polyoxyalkylene polycyclic aryl ether expressed by chemical formula (1) below, fatty acid alkanol amide, polyoxyalkylene sorbitan alkylate, or polyalkylene glycol fatty acid ester
R¹-O-(R²O)ₙ-H (1)
where R¹ is an alkylaryl group with two or more benzene rings or a polycyclic aromatic group having an alkyl group , and R² is an alkylene group having 2 to 3 carbons, and n is an integer in the range of 2 to 40
(b) Anionic surfactants such as phosphates and sulfates
(c) Cationic surfactants such as quaternary ammoniums
(d) High molecular compounds such as polyacrylate, polyvinyl pyrrolidone, polyacrylamide
(e) Layered clay minerals such as kaolinite, halloysite, montmorillonite, illite, and vermiculite
(f) Silica compounds such as colloidal silica

3. A method of producing a water-dispersed flux composition, including solid fine particles containing a carboxy group-containing resin, an activator, a dispersing agent and water, in which all of the solid fine particles have a particle diameter in the range of 0.03 to 20 µm, and the ratio of solid fine particles having a particle diameter of 0.03 to 10 µm is not less than 90% by mass based on the total of solid fine particles (100% by mass), comprising:
adding the carboxy group-containing resin being in the solid state and the activator to a medium comprising water and the dispersing agent,
processing the carboxy group-containing resin in the solid state into fine particles, and
dispersing the fine particles in the medium.

4. An electronic circuit board with electronic components having soldered electronic components and a flux film comprising the water-dispersed flux composition according to claim 1 or 2 on the electronic circuit board.

5. A method of producing an electronic circuit board with electronic components, comprising:
applying the water-dispersed flux composition according to claim 1 or 2 to the electronic circuit board, and
soldering the electronic components to the electronic circuit board.

6. A soldering method employing the water-dispersed flux composition according to claim 1 or 2.
